# EUROPEAN PATENT SPECIFICATION

(11) **EP 0 494 672 B1**
(45) Date of publication and mention of the grant of the patent: **14.06.1995**
(21) Application number: 92100284.6
(22) Date of filing: 09.01.1992
(51) Int. Cl.: B05D 1/00, B05C 5/04

(54) **Method and apparatus for continuously coating a moving metal strip**
Verfahren und Vorrichtung zur Durchlaufbeschichtung eines Metallbleches
Procédé et appareil pour revêtir en continu une bande de métal

(30) Priority: 10.01.1991 AU PK4156/91
(43) Date of publication of application: 15.07.1992
(73) Proprietor: BHP STEEL (JLA) PTY Ltd, Sydney New South Wales 2000 (AU); COURTAULDS (AUSTRALIA) PTY. LTD., Villawood, NSW 2163 (AU)
(72) Inventor: Buecher, Udo Wolfgang, Shellharbour, New South Wales 2529 (AU)
(74) Representative: Fiener, Josef

(56) References cited:
- CH-A- 85 129
- DE-A- 3 919 620
- FR-A- 2 431 363
- US-A- 1 383 740
- US-A- 3 305 392
- US-A- 3 630 802

## Description

This invention relates to the large scale, continuous coating of moving substrate metal strips with ornamental and/or protective coatings of film forming, organic, polymeric materials. Typically the invention is applicable to the production in a steel finishing mill of pre-painted steel strip, such as is used as the starting material in the production of building cladding sheets, appliance cabinets, vehicle bodies and many other sheet metal products.

For the most part, in such production processes the coating is applied to the strip as a liquid paint, in which the constituents, namely the polymeric materials, pigments and maybe inert fillers, are held in a solvent. The paint constituents are left as a film on the strip as a result of the solvent evaporating, either naturally or on being heated. If the film forming polymeric material is of the thermoplastic type, the removal of the solvent virtually completes the process. If the polymeric material is of the thermosetting type, a subsequent heating is required to effect the cross-linking which causes the film to harden.

In large scale plants, the storage, handling and, in particular, the recovery, of the considerable volumes of environmentally hazardous solvents involved, requires care and the provision of expensive equipment, if the working environment is to be satisfactory.

In other situations, it is known to use the so called dry-powder coating process. Briefly stated, this process comprises spraying electrostatically charged, dry particles of a paint composition on to an oppositely charged' article to be coated, and then heating the powder layer to form a film and, if needed, thermoset the film. That process eliminates the solvent, but is not suitable for continuous strip coating because of the severe limitations the application of the powder would impose on the strip speed. Furthermore, powder coatings are inherently thicker than those preferred on stock strip material.

US-A-3 630 802 discloses the deposition of a polymeric material upon a moving metal substrate by melting from a block. However, the deposited polymeric coating is then stripped off from the moving metal carrier belt after the solidification of the polymeric material and then applied to a flexible substrate like a foil or film, such that the surface contacting the carrier belt then forms the outside of the laminate. Furthermore, the thickness of the deposit is controlled by a metering gate, but that gate operates on this surface which contacts the final surface as the stripped-off film is inverted for application to a final substrate. Thus, an extremely polished surface on the carrier belt on which the polymeric film is cast would be required in order to achieve the necessary smooth surface as melt coating tends to leave a rough and patchy coating on the substrate.

Therefore, it is an object of the present invention to provide a coating process which is suitable for use in a high speed, continuous coating plant and which eliminates the need for solvent recovery.

A further disadvantage of conventional practice using liquid coating compositions, is the wastage, and more importantly, the time delays, associated with changing from one coating to another to suit requirements for differently coloured, or otherwise differently coated, products. At such a changeover it is necessary to drain and clean the pipe lines, pumps, applicator and all other equipment contacted by the coating material, to avoid contamination of the fresh coating with the old. This has led to long product runs, with consequent large inventories of finished stock and lack of flexibility in meeting orders for small quantities of seldom required product.

Ideally, production would be scheduled to meet each individual order as received, and another object of the present invention is to provide a continuous strip coating process enabling a changeover time which is small enough to permit that ideal situation to be largely attained.

As indicated above the objects of the invention are to provide a substantially solvent free coating process, which is suitable for use in a continuous, high speed, strip coating mill, and which enables a short changeover time from one coating to another to be attained.

The invention achieves those objects primarily by applying a liquid layer of a paint composition to the strip by pressing a solid block of a high solids content, essentially solvent free, polymer based paint composition against the moving strip, while the strip is hot enough to cause a surface layer of the block contiguous to the strip to soften and be carried away as the liquid layer thereon.

It was found in experiments leading to the invention that thermoplastic polymer based paint compositions were unsuitable, in that such compositions, if they were non-tacky solids at room temperature, took too long to be reduced to a low viscosity liquid when utilising strip temperatures which were feasible in practice. On the other hand, compositions based on thermosetting polymers having relatively low glass transition temperatures performed satisfactorily, provided the as formed liquid layer was smoothed before it had time to increase substantially in viscosity due to cross-linking.

Therefore, the invention consists in a method as defined in claim 1 and in an apparatus as defined in claim 13.

In some instances the pressure between the block and the strip is maintained at a critical value at which the liquid layer is substantially the required thickness for the finished coat of paint, in others the as formed liquid layer is somewhat thicker than desired, and the smoothing is effected while doctoring the liquid layer to the required thickness.

By way of example, an embodiment of the above described invention is described in more detail hereinafter with reference to the accompanying drawings.
Figure 1 is a diagrammatic side elevation of a continuous strip coating production line according to the invention.
Figure 2 is a diagrammatic view of the applying and smoothing equipment of the line of figure 1 drawn to a larger scale.
Figure 3 is a view similar to figure 2 of an alternative smoothing equipment.

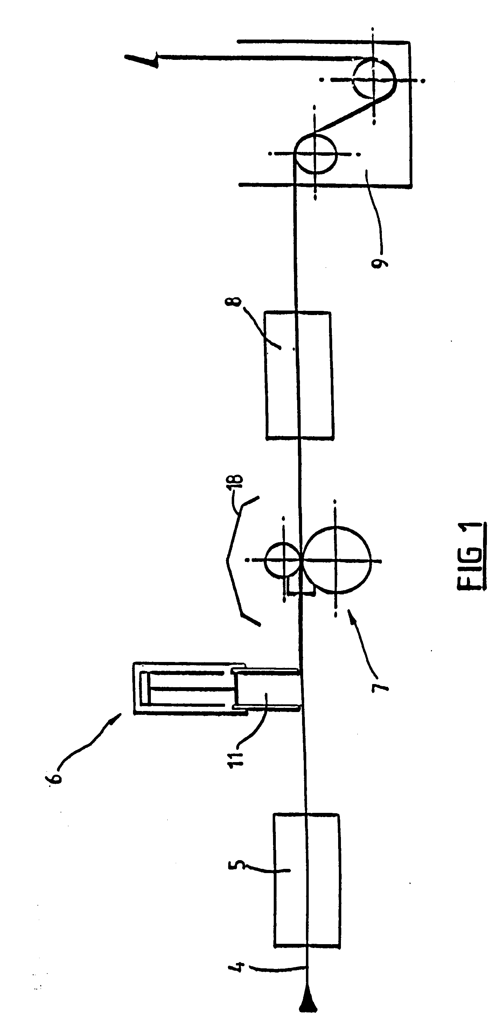

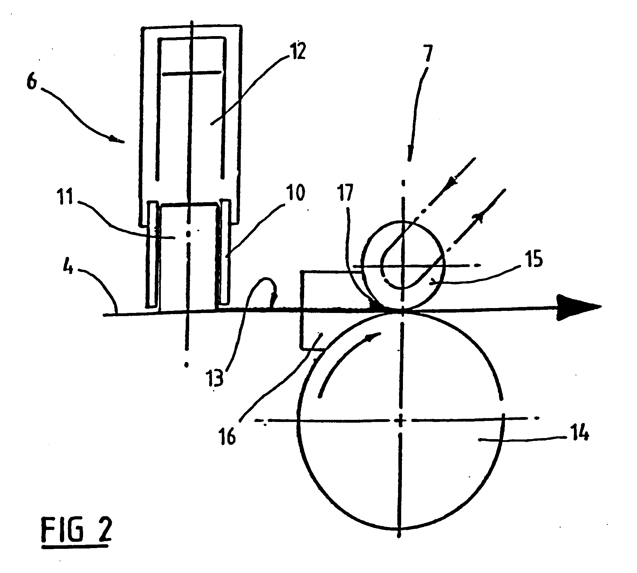

In accordance with the embodiment of the invention illustrated by figures 1 and 2, a steel strip 4, which is to be continuously coated, is caused to travel sequentially through a pre-heating furnace 5, a coating applicator 6, a smoothing device 7, a curing furnace 8, and a quenching bath 9.

The illustrated apparatus may be an integral, final part of a continuous galvanising line, but more usually it is fed from a conventional un-coiler (not shown) loaded with coiled strip from stock. The coated strip emerging from the bath 9 is taken up by a conventional re-coiler (not shown) and the line would be fitted with other conventional adjuncts, such as accumulators and means to maintain tension in the strip.

The incoming strip 4 is pre-treated to render it suitable for receiving a finishing coat of paint, that is to say it would be levelled, cleaned and probably primed. All of these operations may be effected by conventional means. In particular, the strip `may be primed with a solvent based primer composition in the usual manner, wherein the strip with a liquid primer coating on it is passed through a conventional curing furnace to drive off the solvent and cure the primer. The primer coat is preferably very thin, for example within the range of from 3 to 20 microns, preferably about 5 microns, and so requires only very little solvent to be used in its formation. Alternatively, the primer coat may itself be applied by a method or apparatus according to the present invention.

The primed strip emerges from the primer curing furnace at a temperature at least approaching that required for the melt-off of the solid block paint composition. Indeed, in installations where the strip proceeds directly from the priming station to the finish coating station, the priming furnace may be controlled to ensure that the strip leaves it at an appropriate temperature. More usually, however, the primed strip is passed through a dedicated pre-heat furnace 5 to attain that temperature, which is preferably within the range of from 130°C to 210°C, and then passes to the coating applicator 6.

The coating applicator 6 comprises a chute or guide 10 locating a block 11 of the paint composition and a pneumatic or other thrustor 12 urging the block 11 through the guide 10 into contact with the strip 4.

The strip 4, in contact with the block 11, is hotter than the glass transition temperature of the polymeric material in the block and thus a lower surface layer of the block is continuously melted and carried away by the strip as a relatively non-uniform liquid layer 13 thereon. The rate of melt-off is controlled by several parameters, including the contact length of the block and strip in the direction of strip travel, the coating composition, the strip temperature and the strip speed. In experiments leading to the present invention it has been found that if all the mentioned parameters are constant, as would be the case in a normal operating installation, then, within absolute limits set by those parameters, (for example, if the strip temperature were below the glass transition temperature there would be no melt-off, or if the strip speed is excessive or the contact distance very small there would be very little melt-off and the applied liquid coat would necessarily be very thin and maybe patchy) the thickness of the applied liquid layer 13 depends on the pressure between the block and the strip. Within those limits, if the pressure is increased the thickness of the layer 13 increases and, if the pressure is decreased the thickness of the layer decreases.

In a given situation an appropriate pressure may be determined by trial and error. In the illustrated embodiment the operating pneumatic pressure within the thrustor 12 may be kept constant, or it may be increased gradually as the block 11 is consumed, to compensate for the loss of weight in the block and maintain the pressure between the block and the strip substantially constant.

By way of example, it is mentioned that for a strip temperature within the range of from 100 to 210°C, a strip speed within the range of from 20 to 200 metres per minute, a paint composition based on a polymeric resin having a glass transition temperature within the range of from -10 to 40°C and a contact length within the range of from 30 to 300 millimetres, then an appropriate range (depending on the desired paint thickness) for the pressure between the paint block and the strip is from 10 to 100 kilopascals.

The block 11 may be of any high solids, thermosetting polymer based paint composition wherein the polymer has a glass transition temperature appreciably below convenient operating temperatures for the pre-heated strip. Appropriate polymers include polyester, silicone modified polyester, epoxy, acrylic, melamine-formaldehyde, and urethane resins and mixtures thereof.

The liquid layer of paint composition 13 thus formed on the strip 4 is then smoothed and doctored to thickness by the smoothing device 7. That device comprises a steel support roll 14 supporting the strip 4, a resilient doctor roll 15, and weirs 16 disposed one at each edge of the strip 4 to prevent spillage. The roll 14 is rotated so that its surface speed is substantially the same as that of the strip 4, and that part of the roll touching the strip moves in the same direction as the strip. The same may apply to the doctor roll 15 except that its surface speed may be about 10 - 20% of that of the strip. A light pressure is maintained between the rolls and some surplus coating 13 may build up at 17.

The doctor roll 15 may be a rubber coated roll. For example it may comprise a surface layer of about 20mm thickness of a heat resistant silicone or other rubber upon a steel core. That rubber may have a Shore A hardness of from 45 to 65, say about 55.

Thus, the device 7 may be designated as a forward acting, single roll, smoothing device.

For preference the block 11 is of slightly less width than the strip 4, so that narrow edge margins of the strip are free of layer 13 as the strip enters the nip of rolls 14 and 15. Those rolls then spread the liquid layer over the full width of the strip and at the same time slightly reduce its average thickness. That reduction enables the rolls to produce a desirably smooth coating, and the spreading enables the volume of liquid on the strip per unit length of strip to be substantially the same before and after passage between the rolls notwithstanding that reduction. This enables the melt-off rate to be adjusted so that the operation may proceed continuously for lengthy periods without under thickness coatings being produced or excessive spillage of surplus coating material occurring ahead of the nip of rolls 14 and 15.

The passage of the strip through the smoothing device 7 results in a smooth coating of predetermined thickness on the emergent strip.

Notwithstanding that the block 11 is essentially free of solvents, a small quantity of volatiles may be produced by the heating of the paint and thus fume extraction means, indicated by the hood 18 in figure 1, may be provided over device 7.

It should be emphasised that figure 1 is diagrammatic. In practice the applicator 6 and the smoothing device 7 are positioned so that there is insufficient time for liquid layer 13 to increase in viscosity, by cross-linking, to a significant extent before entering the nip of the rolls 14 and 15.

Upon emerging from the smoothing device 7, the coated strip travels through the curing furnace 8, wherein the coating is heated to a curing temperature of say 220-270°C, whereby it is cured.

The cured coating and the strip may then be quenched by passage through the bath 9, or otherwise cooled to room temperature for re-coiling and removal as finished product.

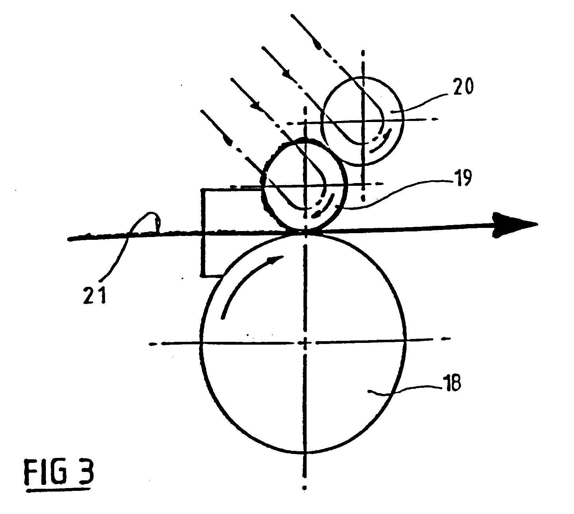

Figure 3 illustrates an alternative smoothing device. It comprises a steel support roll 18, a resilient applicator roll 19 and a steel doctor roll 20.

All of the rolls turn in the directions of the arrows appearing on them in figure 3, and the pressure between the rolls 18 and 19 is relatively high. The device operates as follows. Coating 21 (corresponding to coating 13 of figure 2) is deposited on the strip by the novel, block melt-off type applicator already described. That coating cannot readily pass through the nip of rolls 18 and 19 and is substantially picked up by the latter. The picked up coating on roll 19 is then doctored to thickness and smoothed by the doctor roll 20 as it travels through the nip of rolls 19 and 20. The smoothed coating is then carried on by roll 19 and applied to the strip in much the same way as a conventional liquid coating is applied by a conventional roll applicator. For preference, the surface speed of the applicator roll 19 is from 70 to 130% of the speed of travel of the strip, and the surface speed of the doctor roll 20 is from 10 to 20% of that of the applicator roll 19.

Thus the device of figure 3 may be designated a reverse acting, double roll, smoothing device.

In other embodiments of forward acting, single roll, or reverse acting, double roll, smoothing devices useable in coating procedures according to the invention, the single support rolls 14 and 18 may be replaced by two spaced apart support rolls respectively positioned slightly upstream and downstream of the roll 15 or 19 as the case may be. This provides some resilience between the strip and roll 15 or 19 and renders the device less sensitive to inadvertent variations in the melt-off rate of the applicator.

In still other embodiments, where a slightly lower quality of surface finish may be accepted, the above described roll type, smoothing devices may be replaced by one or two support rolls and a simple, fixed doctor blade.

## Claims

1. A method of continuously coating a metal strip (4) with an adherent polymeric coating composition, comprising the steps of:
continuously moving the metal strip (4);
selecting a solid block (11) of a substantially solvent-free paint composition comprising a thermosetting polymer having a glass transition temperature;
pre-heating the moving metal strip (4) to a preheat temperature above the glass transition temperature;
holding the solid block (11) of said paint composition against the preheated moving metal strip while maintaining sufficient pressure between the solid block (11) and the strip (4) to cause a liquid layer (13, 21) of the paint composition to be carried away from the block (11) on the moving metal strip (4) ;
smoothing said liquid layer (13, 21);
and further heating the smoothed liquid layer (13, 21) to a curing temperature to produce a thermoset adherent coating on the moving metal strip (4).

2. Method according to claim 1 wherein the polymer comprises anyone of a polyester, silicone modified polyester, epoxy, acrylic, melamine-formaldehyde, or urethane resin.

3. Method according to claim 1 or 2 wherein the width of the block (11) is less than that of the strip (4) so that the width of the liquid layer (13, 21) carried away from the block (11) is likewise less than that of the strip (4), and wherein the step of smoothing said layer (13, 21) includes spreading it across the full width of the strip (4).

4. Method according to any of the preceding claims wherein the step of smoothing said layer (13) is effected by a forward acting, single roll smoothing device (15).

5. Method according to any of claims 1 to 3 wherein the step of smoothing said layer (21) is effected by a reverse acting, double roll smoothing device (19, 20).

6. Method according to any of the preceding claims including the further step of quenching said strip (4) and said thermoset coating.

7. Method according to any of the preceding claims wherein said pre-heat temperature is within the range of from 100 to 210°C.

8. Method according to any of the preceding claims wherein said strip (4) moves at a speed within the range of from 20 to 200 metres per minute.

9. Method according to any of the preceding claims wherein said glass transition temperature is within the range of from -10 to 40°C.

10. Method according to any of the preceding claims wherein the contact length of the block (11) and the strip (4) in the direction of travel of the strip (4) is within the range of from 30 to 300 millimetres.

11. Method according to any of the preceding claims wherein the pressure between the strip (4) and the block (11) is within the range of from 10 to 100 kilopascals.

12. Method according to any of the preceding claims wherein said curing temperature is within the range of from 220 to 270°C.

13. Apparatus for effecting a method according to any of the preceding claims, comprising means to cause said strip (4) to travel along a predetermined pass line and further means treating said strip (4) sequentially as it travels along said pass line, said further means comprising a pre-heating furnace (5) adapted to pre-heat the strip (4) to a predetermined pre-heating temperature, a coating applicator (6) adapted to hold a solid block (11) of a paint composition and maintain the block (11) in contact with the preheated strip (4), whereby a liquid layer (13, 21) of the paint composition is applied to the strip (4), smoothing means (7) whereby said liquid layer (13, 21) is spread substantially evenly over one side of the strip (4), and a curing furnace (8) whereby said evenly spread layer (13, 21) is further heated to a curing temperature to produce an adherent coating on the strip (4).

14. Apparatus according to claim 13 wherein said coating applicator (6) includes thrustor means (12) adapted to maintain a substantially constant contact pressure between said block (11) and said strip (4).

15. Apparatus according to claim 13 or 14 wherein said smoothing means (7) is a forward acting, single roll smoothing device (15) and the surface speed of the single roll (15) of said smoothing device is within the range of from 10 to 20 % of the speed of travel of the strip (4).

16. Apparatus according to claim 13 or 14 wherein said smoothing means (7) is a reverse acting, double roll smoothing device (19, 20) and the surface speed of the applicator roll (19) of the smoothing device is from 70 to 130 % of the speed of travel of the strip (4) and wherein the surface speed of the doctor roll (20) of said device is from 10 to 20 % of that of the applicator roll (19).

17. Apparatus according to claim 15 or 16 wherein said smoothing device (7) comprises two spaced apart support rolls (14, 18) for the strip (4).

## Patentansprüche

1. Verfahren zur Durchlaufbeschichtung eines Metallbleches (4) mit einer anhaftenden, polymeren Beschichtungszusammensetzung, mit den Schritten:
Fortlaufendes Bewegen des Metallbleches (4);
Auswählen eines festen Blocks (11) einer im wesentlichen lösungsmittelfreien Farbzusammensetzung, die ein in der Hitze aushärtendes Polymer mit einer Glasumwandlungstemperatur enthält;
Vorwärmen des vorbeilaufenden Metallbleches (4) auf eine Vorwärmtemperatur über der Glasumwandlungstemperatur;
Halten des festen Blocks (11) der Farbzusammensetzung gegen das vorgewärmte vorbeilaufende Metallblech unter gleichzeitiger Aufrechterhaltung eines ausreichenden Drucks zwischen dem festen Block (11) und dem Blech (4), so daß veranlaßt wird, daß eine flüssige Schicht (13, 21) der Farbzusammensetzung von dem Block (11) weg auf das vorbeilaufende Metallblech (4) aufgetragen wird;
Glätten der flüssigen Schicht (13, 21); und
weiteres Erhitzen der geglätteten, flüssigen Schicht (13, 21) auf eine Aushärtetemperatur zur Erzeugung einer in der Hitze ausgehärteten Haftbeschichtung auf dem vorbeilaufenden Metallblech (4).

2. Verfahren nach Anspruch 1, wobei das Polymer ein Polyester-, silikonmodifiziertes Polyester-, Epoxyd-, Acryl-, Melamin-Formaldehyd- oder Urethan-Harz enthält.

3. Verfahren nach Anspruch 1 oder 2, wobei die Breite des Blocks (11) geringer ist als diejenige des Bleches (4), so daß die Breite der von dem Block (11) weg abgetragenen flüssigen Schicht (13, 21) ebenso geringer ist als diejenige des Bleches (4), und wobei der Schritt Glätten der Schicht (13, 21) ihre Verteilung über die gesamte Breite des Bleches (4) umfaßt.

4. Verfahren nach einem der vorhergehenden Ansprüche, wobei der Schritt Glätten der Schicht (13) durch eine vorwärtslaufende Einzelwalzenglättungsvorrichtung (15) ausgeführt wird.

5. Verfahren nach einem der Ansprüche 1 bis 3, wobei der Schritt Glätten der Schicht (21) durch eine rückwärtslaufende Doppelwalzenglättungsvorrichtung (19, 20) ausgeführt wird.

6. Verfahren nach einem der vorhergehenden Ansprüche, mit dem weiteren Schritt Abkühlen des Bleches (4) und der in der Hitze ausgehärteten Beschichtung.

7. Verfahren nach einem der vorhergehenden Ansprüche, wobei die Vorheiztemperatur im Bereich von 100 bis 210°C liegt.

8. Verfahren nach einem der vorhergehenden Ansprüche, wobei sich das Blech (4) mit einer Geschwindigkeit im Bereich von 20 bis 200 m pro Minute bewegt.

9. Verfahren nach einem der vorhergehenden Ansprüche, wobei die Glasumwandlungstemperatur im Bereich von -10 bis 40°C liegt.

10. Verfahren nach einem der vorhergehenden Ansprüche, wobei die Kontaktlänge des Blocks (11) und des Bleches (4) in Fortbewegungsrichtung des Bleches (4) im Bereich von 30 bis 300 mm liegt.

11. Verfahren nach einem der vorhergehenden Ansprüche, wobei der Druck zwischen dem Blech (4) und dem Block (11) im Bereich von 10 bis 100 Kilopascal liegt.

12. Verfahren nach einem der vorhergehenden Ansprüche, wobei die Aushärtetemperatur im Bereich von 220 bis 270°C liegt.

13. Vorrichtung zur Durchführung eines Verfahrens nach einem der vorhergehenden Ansprüche, mit Mitteln, die bewirken, daß das Blech (4) sich entlang einer vorbestimmten Durchgangsstrecke bewegt und weiteren Mitteln, die das Blech (4) nacheinander behandeln, wenn es sich entlang der Durchgangsstrecke bewegt, wobei die weiteren Mittel einen Vorwärmofen (5) umfassen, der geeignet ist, das Blech (4) auf eine vorbestimmte Vorheiztemperatur vorzuwärmen, einen Beschichtungsaufträger (6), der geeignet ist, einen festen Block (11) einer Farbzusammensetzung festzuhalten und den Block (11) in Kontakt mit dem vorgewärmten Blech (4) zu halten, wodurch eine flüssige Schicht (13, 21) der Farbzusammensetzung auf das Blech (4) aufgebracht wird, Glättungsvorrichtungen (7), durch die die flüssige Schicht (13, 21) im wesentlichen gleichmäßig über eine Seite des Bleches (4) verteilt wird, und einen Trockenofen (8), durch den die gleichmäßig verteilte Schicht (13, 21) auf eine Aushärtetemperatur weitererhitzt wird, um eine Haftbeschichtung auf dem Blech (4) zu erzeugen.

14. Vorrichtung nach Anspruch 13, wobei der Beschichtungsaufträger (6) Druckmittel (12) aufweist, die geeignet sind, einen im wesentlichen konstanten Anpreßdruck zwischen dem Block (11) und dem Blech (4) aufrechtzuerhalten.

15. Vorrichtung nach Anspruch 13 oder 14, wobei die Glättungsvorrichtung (7) eine vorwärtslaufende Einzelwalzenglättungsvorrichtung (15) ist und die Oberflächengeschwindigkeit der Einzelwalze (15) der Glättungsvorrichtung im Bereich von 10 bis 20 % der Fortbewegungsgeschwindigkeit des Bleches (4) liegt.

16. Vorrichtung nach Anspruch 13 oder 14, wobei die Glättungsvorrichtung (7) eine rückwärtslaufende Doppelwalzenglättungsvorrichtung (19, 20) ist und die Oberflächengeschwindigkeit der Aufträgerwalze (19) der Glättungsvorrichtung zwischen 70 und 130 % der Fortbewegungsgeschwindigkeit des Bleches (4) beträgt, und wobei die Oberflächengeschwindigkeit der Abstreifwalze (20) der Vorrichtung zwischen 10 und 20 % derjenigen der Aufträgerwalze (19) beträgt.

17. Vorrichtung nach Anspruch 15 oder 16, wobei die Glättungsvorrichtung (7) zwei beabstandete Abstützwalzen (14, 18) für das Blech (4) aufweist.

## Revendications

1. Procédé pour revêtir en continu une bande de métal (4) avec une composition de revêtement polymère adhérente, comprenant les étapes consistant à:
déplacer en continu la bande de métal (4); choisir un bloc solide (11) d'une composition de peinture essentiellement exempte de solvant comprenant un polymère thermodurcissable caractérisé par une température de transition vitreuse; soumettre la bande de métal mobile (4) à un préchauffage à une température de préchauffage supérieure à la température de transition vitreuse; appliquer le bloc solide (11) de ladite composition de peinture contre la bande de métal mobile préchauffée tout en exerçant une pression suffisante entre le bloc solide (11) et la bande (4) afin qu'une couche liquide (13, 21) de la composition de peinture soit détachée du bloc (11) et entraînée par la bande de métal (4); lisser ladite couche liquide (13, 21) et poursuivre le chauffage de la couche liquide lissée (13, 21) jusqu'à une température de cuisson en vue de former un revêtement adhérent thermodurcissable sur la bande de métal mobile (4).

2. Procédé selon la revendication 1 dans lequel le polymère comprend indifféremment une résine à base de polyester, une résine à base de polyester modifiée par une silicone, une résine époxy, une résine acrylique, une résine à base de mélamine-formaldéhyde, ou une résine à base d'uréthanne.

3. Procédé selon la revendication 1 ou 2, dans lequel la largeur du bloc (11) est inférieure à celle de la bande (4) de sorte que la largeur de la couche liquide emportée après s'être détachée du bloc (11) est également inférieure à celle de la bande (4), et dans lequel l'étape de lissage de ladite couche (13, 21) comprend l'étalement de cette couche sur toute la largeur de la bande (4).

4. Procédé selon l'une quelconque des revendications précédentes dans lequel l'étape de lissage de ladite couche (13) est conduite par un dispositif de lissage à rouleau unique tournant vers l'avant (15).

5. Procédé selon l'une quelconque des revendications 1 à 3 dans lequel l'étape de lissage de ladite couche (21) est réalisée par un dispositif de lissage à deux rouleaux tournant en sens inverse (19, 20).

6. Procédé selon l'une quelconque des revendications précédentes comprenant en outre une étape de refroidissement de ladite bande (4) et dudit revêtement thermodurcissable.

7. Procédé selon l'une quelconque des revendications précédentes dans lequel ladite température de préchauffage est comprise dans l'intervalle allant de 100 à 210°C.

8. Procédé selon l'une quelconque des revendications précédentes dans lequel ladite bande (4) se déplace à une vitesse comprise dans l'intervalle allant de 20 à 200 mètres par minute.

9. Procédé selon l'une quelconque des revendications précédentes dans lequel la température de transition vitreuse est comprise dans l'intervalle allant de -10 à 40°C.

10. Procédé selon l'une quelconque des revendications précédentes dans lequel la longueur de la région de contact entre la bande (4) et le bloc (11) dans le sens de défilement de la bande (4) est comprise dans l'intervalle allant de 30 à 300 millimètres.

11. Procédé selon l'une quelconque des revendications précédentes dans lequel la pression entre la bande (4) et le bloc (11) est comprise dans l'intervalle allant de 10 à 100 kilopascals.

12. Procédé selon l'une quelconque des revendications précédentes dans lequel ladite température de cuisson est comprise dans l'intervalle allant de 220 à 270°C.

13. Appareil pour mettre en oeuvre le procédé conforme à l'une quelconque des revendications précédentes, comprenant des moyens pour entraîner ladite bande (4) le long d'une chaîne de fabrication défini à l'avance et des moyens auxiliaires pour traiter ladite bande (4) par étapes successives à mesure qu'elle se déplace le long de ladite chaîne de fabrication, lesdits moyens auxiliaires comprenant une étuve de préchauffage (5) appropriée au préchauffage de la bande (4) jusqu'à une température de préchauffage déterminée à l'avance, un applicateur de revêtement (6) servant convenablement de support d'un bloc solide (11) de composition de peinture et approprié au maintien du bloc (11) en contact avec la bande préchauffée (4), de telle manière qu'une couche liquide (13, 21) de la composition de peinture soit appliquée à la bande (4), des moyens de lissage (7) de telle manière que ladite couche liquide (13, 21) soit étalée par étapes successives de manière quasi uniforme sur l'un des côtés de la bande (4), et une étuve de cuisson (8) de telle manière que ladite couche uniformément étalée (13, 21) subisse un chauffage plus poussé jusqu'à une température de cuisson en vue de former un revêtement adhérent à la bande (4).

14. Appareil selon la revendication 13 dans lequel ledit applicateur de revêtement (6) comprend des moyens de propulsion (12) capables de maintenir une pression de contact pratiquement constante entre ledit bloc (11) et ladite bande (4).

15. Appareil selon la revendication 13 ou 14 dans lequel ledit moyen de lissage (7) est un dispositif de lissage à rouleau unique tournant vers l'avant et la vitesse périphérique du rouleau unique (15) dudit dispositif de lissage est comprise dans l'intervalle allant de 10 à 20% de la vitesse de déplacement de la bande (4).

16. Appareil selon la revendication 13 ou 14 dans lequel ledit moyen de lissage (7) est un dispositif de lissage à deux rouleaux tournant en sens inverse (19, 20) et la vitesse périphérique du rouleau d'application (19) du dispositif de lissage varie de 70 à 130% de la vitesse de déplacement de la bande (4) et dans lequel la vitesse périphérique du rouleau maître (20) dudit dispositif varie de 10 à 20% de celle du rouleau d'application (19).

17. Appareil selon la revendication 15 ou 16 dans lequel ledit dispositif de lissage (7) comprend deux rouleaux de support écartés (14, 18) servant à maintenir la bande (4).
